# EUROPÄISCHE PATENTSCHRIFT

(11) **EP 1 459 077 B1**
(45) Veröffentlichungstag und Bekanntmachung des Hinweises auf die Patenterteilung: **09.06.2010**
(21) Anmeldenummer: 02790403.6
(22) Anmeldetag: 19.11.2002
(51) Int. Cl.: G01R 31/28, A47L 15/00

(54) **VERFAHREN ZUR ÜBERPRÜFUNG DER ELEKTRISCHEN SICHERHEIT EINES HAUSHALTGERÄTS UND ENTSPRECHENDES HAUSHALTGERÄT**
METHOD FOR CHECKING THE ELECTRICAL SAFETY OF A HOUSEHOLD APPLIANCE, AND CORRESPONDING HOUSEHOLD APPLIANCE
PROCEDE DE CONTROLE DE LA SECURITE ELECTRIQUE D'UN APPAREIL MENAGER, ET APPAREIL MENAGER CORRESPONDANT

(30) Priorität: 21.12.2001 DE 10163197
(43) Veröffentlichungstag der Anmeldung: 22.09.2004
(73) Patentinhaber: BSH Bosch und Siemens Hausgeräte GmbH, 81739 München (DE)
(72) Erfinder: ROTHAUSZKY, Christian, 89441 Medlingen (DE); ROSENBAUER, Michael, 86756 Reimlingen (DE); HERING, Reinhard, 89438 Holzheim (DE)
(86) Internationale Anmeldenummer: PCT/EP2002/012946
(87) Internationale Veröffentlichungsnummer: WO 2003/054562

(56) Entgegenhaltungen:
- DE-A- 4 219 970
- DE-A- 19 853 511
- DE-A1- 4 421 361
- FR-A- 2 399 826
- GB-A- 2 283 870

## Beschreibung

Die Erfindung betrifft ein Verfahren zur Überprüfung der elektrischen Sicherheit eines Haushaltgeräts, das mehrere elektrische Komponenten als Stromverbraucher aufweist, sowie ein entsprechendes Haushaltgerät.

Haushaltgeräte - beispielsweise Geschirrspülmaschinen -, die bekanntlich mehrere Stromverbraucher wie Pumpen, Heizungen etc. aufweisen, unterliegen einer individuellen Überprüfung ihrer elektrischen Sicherheit üblicherweise nicht. Es ist die elektrische Sicherheit lediglich über die bekanntlich im Haushalt, in dem das Haushaltgerät eingesetzt wird, ohnehin vorhandenen Sicherungen gewährleistet. Dies reicht aber für die Überwachung des einzelnen Haushaltgeräts in den meisten Fällen nicht aus, da über die bekannten Haus-Sicherungen normalerweise Stromkreise mit mehreren Steckdosen abgesichert werden. Daher sind diese Haus-Sicherungen auf einen größeren Stromverbrauch eingestellt und zu träge in der Reaktion auf gerätebezogene Problemfälle. Ein derartiger Problemfall entsteht beispielsweise durch Kriechströme im Gerät, die gegebenenfalls zu elektrischen Schlägen am Gerät führen. Auch können die elektrischen Komponenten - z.B. durch Abnutzung oder falsche Handhabung - mit der Zeit fehlerhaft sein, so dass die elektrische Sicherheit des Haushaltgeräts nicht mehr gegeben ist.

Aus der DE 44 21 361 A1 ist eine elektronische Steuerungseinrichtung für ein gasbeheiztes Gerät bekannt, das aus Sicherheitsgründen zwei unabhängige Sicherheitspfade aufweist. Der erste Sicherheitspfad wird überwacht, indem ein 1 kHz-Signal auf Abweichung von einem Frequenzband überwacht wird, während der zweite Sicherheitspfad überwacht, indem an hand einer Messung an einem Messwiderstand festegestellt wird, ob im Stromkreis ein elektrischer Strom fließt oder nicht.

Aus der GB 2 283 870 A ist eine Vorrichtung zum Erfassen von elektrischen Leckströmen bekannt, deren Stärke unterhalb der Auslösegrenze von elektrischen Sicherungen liegt. Hierzu sind eine Anzeige und ein elektrischer Widerstand in Reihe geschaltet und zwischen einem Neutralleiter und dem Erdungsleiter angeordnet. Die Anzeige leuchtet, um anzuzeigen, dass ein elektrischer Leckstrom die Anzeige und den elektrischen Widerstand fließt.

Der Erfindung liegt daher die Aufgabe zu Grunde, ein Verfahren und ein Haushaltgerät anzugeben, durch das sich auf möglichst einfache Art und Weise die elektrische Sicherheit des Haushaltgeräts besser überwachen lässt.

Diese Aufgabe wird hinsichtlich des Verfahrens durch die Merkmale des Patentanspruchs 1 und in Bezug auf das Haushaltgerät durch die Merkmale des Patentanspruchs 9 erfindungsgemäß gelöst. Weiterbildungen der Erfindung sind in den Unteransprüchen angegeben.

Das Verfahren gemäß dem Gegenstand der Erfindung sieht vor,
das für die elektrischen Komponenten jeweils ein Soll-Wert der zulässigen Stromaufnahme des Haushaltgeräts eingestellt wird,
dass abhängig von den in Betrieb genommenen elektrischen Komponenten ein Ist-Wert der Stromaufnahme des Hauhaltgeräts gemessen und mit dem entsprechenden Soll-Wert verglichen wird, und
dass bei Überschreiten des Soll-Werts eine Sicherheitsmaßnahme ausgelöst wird.

Das Haushaltgerät gemäß dem Gegenstand der Erfindung verfügt über eine Steuereinrichtung, die aufweist
Mittel zur Einstellung jeweils eines Soll-Werts der zulässigen Stromaufnahme für die elektrischen Komponenten des Haushaltgeräts,
Mittel zum Messen eines Ist-Werts der Stromaufnahme des Hauhaltgeräts abhängig von den in Betrieb genommenen elektrischen Komponenten und Mittel zum Vergleichen des Ist-Werts mit dem entsprechenden Soll-Wert, und
Mittel zum Auslösen einer Sicherheitsmaßnahme bei Überschreiten des Soll-Werts.

Durch den erfindungsgemäßen Soll-Ist-Wert Vergleich, der durch Festlegung der zulässigen Stromaufnahme der einzelnen elektrischen Komponenten beispielsweise vor Geräte-Inbetriebnahme oder in einem Kundendienstfalle usw. - vorzugsweise vom Gerätehersteller - sowie durch Messung der tatsächlichen Stromaufnahme bei Geräte-Betrieb abhängig von den eingeschalteten Komponenten geräteindividuell erfolgt, kann die elektrische Sicherheit des Haushaltgeräts wesentlich verbessert werden. Sie hängt insbesondere nicht mehr von den Haus-Sicherungen ab, die individuelle geräteabhängige Erhöhungen des Stromverbrauchs - z.B. durch gefährliche Kriechströme oder fehlerhafte Komponenten - nicht detektieren können, wie dies erst mit der Erfindung möglich ist. Die Steuereinrichtung des Haushaltgeräts, die die Mittel gemäß dem Gegenstand der Erfindung aufweist, gibt in vorteilhafter Weise abhängig von dem Betrieb - d.h. z.B. von dem gewählten Programm - vor, welche Komponenten als Stromverbraucher eingeschaltet sind, so dass dann die Ermittlung des Soll-Werts und des Ist-Werts für den Vergleich des Stromverbrauchs individuell entsprechend der aktuellen Betriebsart - Spülprogramm und/oder Trockenprogramm usw. - ausgeführt und bei Überschreiten des Soll-Werts durch den Ist-Wert die Sicherheitsmaßnahme ausgelöst werden. Weiterhin ist die Stromaufnahme der einzelnen Stromverbraucher in den ev. unterschiedlichen einzelnen Teilprogrammschritten aufgrund eines vom Benutzer ausgewählten oder automatisch ablaufenden Behandlungsprogramms bekannt, so dass an bekannten Zeitpunkten der Teilprogrammschritte, an denen nur ein Stromverbraucher betrieben wird, durch den erfindungsgemäßen Soll-Ist-Wert Vergleich nur dieser einzelne Stromverbraucher überprüft wird, also auch eine Überprüfung der einzelnen Stromverbraucher erfolgt und ev. eine gesonderte Maßnahme in Bezug auf einzelne Stromverbraucher möglich wird. Auf eine gesonderte elektrische Absicherung der einzelnen Stromverbraucher kann somit verzichtet werden. Mit der Erfindung wurde ein Verfahren und ein Haushaltgerät geschaffen, durch das sich auf möglichst einfache Art und Weise die elektrische Sicherheit des Haushaltgeräts besser überwachen lässt.

Es hat sich gemäß einer Weiterbildung der Erfindung als günstig erwiesen, dass der Soll-Wert einen gegenüber dem tatsächlich gemessenen Wert der Stromaufnahme des Haushaltgeräts erhöhten Toleranzwert umfasst. Durch den Toleranzwert - der vorzugsweise voreinstellbar ist - kann für das Haushaltgerät ein zusätzlich erhöhter Sicherheitswert gegenüber der Normal-Stromaufnahme eingestellt werden. Ferner sind die daher vorteilhafterweise einsetzbaren Stromverbraucher mit größerem Toleranzbereich kostengünstiger und einfacher in der Fertigung einsetzbar.

Die bevorzugten Sicherheitsmaßnahmen gemäß alternativer Weiterbildungen der Erfindung bestehen darin, dass das Haushaltgerät abgeschaltet wird, dass eine oder mehrere elektrische Komponenten abgeschaltet werden oder dass ein akustisches und/oder ein optisches Warnsignal am Haushaltgerät ausgegeben wird.

Das Verfahren gemäß der Erfindung ist vorzugsweise für beliebige wasserführende Haushaltgeräte, besonders aber für Geschirrspülmaschinen vorteilhaft einsetzbar. Die Geschirrspülmaschine weist bekanntlich zur Aufnahme von Spülgut einen möglichst großzügig bemessenen Spülbehälter auf, der durch eine Gerätetür geöffnet und geschlossen werden kann. Eine Steuereinrichtung, die das vom Benutzer der Geschirrspülmaschine ausgewählte Programm -, z.B. ein Spülprogramm - in seinem Ablauf steuert, kennt die abhängig von der Betriebsart eingeschalteten elektrischen Komponenten als Stromverbraucher. Dies sind im vorliegenden Beispiel eine Umwälzpumpe und/oder eine Laugenpumpe zur Bewegung der Reinigungsflüssigkeit bzw. Laugenflüssigkeit und/oder eine Heizung zur Erwärmung der Reinigungsflüssigkeit bzw. Laugenflüssigkeit, usw.. Wenn die Stromaufnahme vermessen wird, erfolgt der erfindungsgemäße Soll-Ist-Wert Vergleich für die Stromaufnahme. Überschreitet der tatsächlich aufgenommene Strom - erkennbar an dem gemessenen Ist-Wert - den erlaubten Soll-Wert als Sicherheitswert - ggf. unter Berücksichtigung des voreinstellbaren gegenüber der Normal-Stromaufnahme erhöhten Toleranzwertes - beispielsweise für eine Pumpe, kann die gesamte Geschirrspülmaschine oder die Einzel-Komponente, d.h. im Beispielsfalle die Pumpe von der Steuereinrichtung automatisch abgeschaltet oder zumindest ein akustisches und/oder optisches Warnsignal an der oberhalb der Tür der Geschirrspülmaschine angeordneten Bedienblende ausgegeben werden.

Zuvor wurden beim Hersteller beispielsweise nach der Funktions- und Sicherheitsüberprüfung der Geschirrspülmaschine im Werk die einzelnen elektrischen Komponenten als Stromverbraucher bei konstanter Spannung vermessen und entsprechende Soll-Werte generiert und in der Steuereinrichtung gespeichert. Damit brauchen Bauteiltoleranzen nicht mehr berücksichtigt zu werden. Nachdem die Steuereinrichtung die Netzspannung für die Erkennung eines Netzausfalls bereits vermessen hat, kann der Soll-Wert inklusive dem voreinstellbaren Toleranzwert der tatsächlich anliegenden Spannung angepasst werden.

Mit der Erfindung wurde ein Verfahren und ein Haushaltgerät geschaffen, durch das sich auf möglichst einfache Art und Weise die elektrische Sicherheit des Haushaltgeräts besser überwachen lässt.

## Patentansprüche

1. Verfahren zur Überprüfung der elektrischen Sicherheit eines Haushaltgeräts, das mehrere elektrische Komponenten als Stromverbraucher aufweist,
**dadurch gekennzeichnet,**
**dass** für die elektrischen Komponenten jeweils ein Soll-Wert der zulässigen Stromaufnahme des Haushaltgeräts eingestellt wird,
**dass** abhängig von den in Betrieb genommenen elektrischen Komponenten ein Ist-Wert der Stromaufnahme des Hauhaltgeräts gemessen und mit dem entsprechenden Soll-Wert verglichen wird, und
**dass** bei Überschreiten des Soll-Werts eine Sicherheitsmaßnahme ausgelöst wird, und
**dass** der Soll-Wert einen gegenüber dem tatsächlich gemessenen Wert der Stromaufnahme des Haushaltgeräts erhöhten Toleranzwert umfasst.

2. Verfahren nach Anspruch 1, **dadurch gekennzeichnet, dass** der Toleranzwert voreingestellt werden kann.

3. Verfahren nach einem der Ansprüche 1 bis 2, **dadurch gekennzeichnet, dass** als Sicherheitsmaßnahme das Haushaltgerät abgeschaltet wird.

4. Verfahren nach einem der Ansprüche 1 bis 2, **dadurch gekennzeichnet, dass** als Sicherheitsmaßnahme eine oder mehrere elektrische Komponenten abgeschaltet werden.

5. Verfahren nach einem der Ansprüche 1 bis 2, **dadurch gekennzeichnet, dass** als Sicherheitsmaßnahme ein akustisches und/oder ein optisches Warnsignal am Haushaltgerät ausgegeben wird.

6. Verfahren nach einem der vorhergehenden Ansprüche, **dadurch gekennzeichnet, dass** das Haushaltgerät ein wasserführendes Haushaltgerät ist.

7. Verfahren nach einem der vorhergehenden Ansprüche, **dadurch gekennzeichnet, dass** das Haushaltgerät eine Geschirrspülmaschine ist.

8. Haushaltgerät zur Durchführung des Verfahrens nach einem der vorhergehenden Ansprüche, **dadurch gekennzeichnet, dass** es über eine Steuereinrichtung verfügt, die aufweist
Mittel zur Einstellung jeweils eines Soll-Werts der zulässigen Stromaufnahme für die elektrischen Komponenten des Haushaltgeräts, wobei der Soll-Wert einen ge-genüber dem tatsächlichen Wert der Stromaufnahme des Haushaltsgeräts erhöhten Toleranzwert umfasst
Mittel zum Messen eines Ist-Werts der Stromaufnahme des Hauhaltgeräts abhängig von den in Betrieb genommenen elektrischen Komponenten und Mittel zum Vergleichen des Ist-Werts mit dem entsprechenden Soll-Wert, und
Mittel zum Auslösen einer Sicherheitsmaßnahme bei Überschreiten des Soll-Werts.

## Claims

1. Method of checking the electrical safety of a domestic appliance, which has several electrical components as current loads, **characterised in that** a respective target value of the permissible power consumption of the domestic appliance is set for each of the electrical components, that depending on the electrical components placed in operation an actual value of the power consumption of the domestic appliance is measured and compared with the corresponding target value and that a safety measure is triggered if the target value is exceeded, and that the target value comprises a tolerance value increased relative to the actually measured value of the power consumption of the domestic appliance.

2. Method according to claim 1, **characterised in that** the tolerance value can be preset.

3. Method according to one of claims 1 and 2, **characterised in that** as safety measure the domestic appliance is switched off.

4. Method according to one of claims 1 and 2, **characterised in that** as safety measure one or more electrical components are switched off.

5. Method according to one of claims 1 and 2, **characterised** that as safety measure an acoustic and/or optical warning signal is issued at the domestic appliance.

6. Method according to any one of the preceding claims, **characterised in that** the domestic appliance is a water-conducting domestic appliance.

7. Method according to any one of the preceding claims, **characterised in that** the domestic appliance is a dishwashing machine.

8. Domestic appliance for performance of a method according to any one of the preceding claims, **characterised in that** it has a control device which comprises means for setting a respective target value of the permissible power consumption for the electrical components of the domestic appliance, wherein the target value comprises a tolerance value increased relative to the actual value of the power consumption of the domestic appliance, means for measuring an actual value of the power consumption of the domestic appliance depending on the electrical components placed in operation and means for comparing the actual value with the corresponding target value and means for triggering a safety measure if the target value is exceeded.

## Revendications

1. Procédé de contrôle de la sécurité électrique d'un appareil ménager présentant plusieurs composants électriques en tant que consommateurs de courant,
**caractérisé en ce**
**qu'**une valeur théorique de la consommation de courant admissible de l'appareil ménager est respectivement réglée pour les composants électriques,
**qu'**en fonction des composants électriques mis en service, une valeur réelle de la consommation de courant de l'appareil ménager est mesurée et comparée à la valeur théorique correspondante, et
**qu'**une mesure de sécurité est déclenchée en cas de dépassement de la valeur théorique, et
**que** la valeur théorique comprend une valeur de tolérance augmentée par rapport à la valeur effectivement mesurée de la consommation de courant de l'appareil ménager.

2. Procédé selon la revendication 1, **caractérisé en ce que** la valeur de tolérance peut être préréglée.

3. Procédé selon l'une quelconque des revendications 1 à 2, **caractérisé en ce que** l'appareil ménager est mis hors circuit en tant que mesure de sécurité.

4. Procédé selon l'une quelconque des revendications 1 à 2, **caractérisé en ce qu'**un ou plusieurs composants électriques sont mis hors circuit en tant que mesure de sécurité.

5. Procédé selon l'une quelconque des revendications 1 à 2, **caractérisé en ce qu'**un signal d'alerte sonore et/ou visuel est sorti sur l'appareil ménager en tant que mesure de sécurité.

6. Procédé selon l'une quelconque des revendications précédentes, **caractérisé en ce que** l'appareil ménager est un appareil ménager à circulation d'eau.

7. Procédé selon l'une quelconque des revendications précédentes, **caractérisé en ce que** l'appareil ménager est un lave-vaisselle.

8. Appareil ménager pour la réalisation du procédé selon l'une quelconque des revendications précédentes, **caractérisé en ce qu'**il dispose d'un dispositif de commande qui présente
des moyens pour régler respectivement une valeur théorique de la consommation de courant admissible pour les composants électriques de l'appareil ménager, la valeur théorique comprenant une valeur de tolérance augmentée par rapport à la valeur effectivement mesurée de la consommation de courant de l'appareil ménager,
des moyens pour mesurer une valeur réelle de la consommation de courant de l'appareil ménager en fonction des composants électriques mis en service, et des moyens pour comparer la valeur réelle à la valeur théorique correspondante, et
des moyens pour déclencher une mesure de sécurité en cas de dépassement de la valeur théorique.
